(19) Europäisches Patentamt
European Patent Office
Office européen des brevets

(11) **EP 2 012 306 A1**

(12) **EUROPEAN PATENT APPLICATION**
published in accordance with Art. 153(4) EPC

(43) Date of publication:
**07.01.2009 Bulletin 2009/02**

(51) Int Cl.:
*G10L 19/02* (2006.01)    *H03M 7/30* (2006.01)

(21) Application number: **07742778.9**

(22) Date of filing: **24.04.2007**

(86) International application number:
**PCT/JP2007/059343**

(87) International publication number:
**WO 2007/126106 (08.11.2007 Gazette 2007/45)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **26.04.2006 JP 2006122294**

(71) Applicant: **Sony Corporation Tokyo 108-0075 (JP)**

(72) Inventor: **SUWABE, Kaoru Tokyo 108-0075 (JP)**

(74) Representative: **Thévenet, Jean-Bruno et al Cabinet Beau de Loménie 158, rue de l'Université 75340 Paris Cédex 07 (FR)**

(54) **ENCODING METHOD AND ENCODING DEVICE**

(57) At S1, an initial value of a common scale factor is calculated. Thereafter, at S11, the initial value is corrected. A value of which the difference between the initial value and the final value of the preceding frame is added to the initial value of the current frame is a corrected initial value of the common scale factor. Scaling is performed with the corrected initial value. At S3, if it has been determined that quantizing noise of each sub band do not exceed a permissible noise, the flow advances to S5. At S5, variable length encoding is performed. At S6, it is determined whether or not the encoded code amount exceeds a target code amount. If it has been determined that the code amount exceed the target code amount, the flow advances to S7. At S7, the common scale factor is changed such that the quantizing step size becomes large and the quantizing process is restored. Thereafter, the process is repeated until it has been determined that the code amount do not exceed the target code amount. The corrected initial value allows the process time to become short.

# Fig. 1

EP 2 012 306 A1

**Description**

Technical Field

The present invention relates to an encoding method and an encoding apparatus for compressing the code amount of a digital information signal such as an audio signal.

Background Art

As one encoding system for compressing an audio signal, ISO/IEC 13818-78 (MPEG2-AAC (Advanced Audio Coding) hereinafter referred to as the AAC audio encoding) standardized by ISO is known.
In the AAC audio encoding, a music signal or the like is divided into a plurality of time blocks. Orthogonal transform, for example, modified discrete cosine transform (hereinafter referred to as MDCT (Modified DCT)) is performed for each block and thereby transform coefficients (hereinafter referred to as MDCT coefficients) are obtained. The MDCT coefficients are scaled by a scale factor. The scaled transform coefficients are quantified and the quantified values are encoded according to the Huffman encoding system.
In the AAC audio encoding, when transform coefficients are divided into a plurality of frequency regions (referred to as sub bands), a common scale factor in common with all sub bands and a sub band scale factor that differs each sub band are adaptively changed for a quantizing noise distribution taking into account of a psychology auditory model such that the code amount that has been variable-length encoded becomes close to a target code amount (transmission rate) specified in a standard or a specification of a product. A code amount that can be assigned for each encoding frame is calculated. A scaling factor is updated such that the code amount does not exceed the target code amount assuming that the calculated code amount is the target code amount of each encoding frame. An encoding frame is an audio frame having a length of which an audio stream having a predetermined transmission rate is divided by a predetermined number of audio samples, eg, 1024 audio samples. In the following description, an encoding frame is simply referred to as a frame.

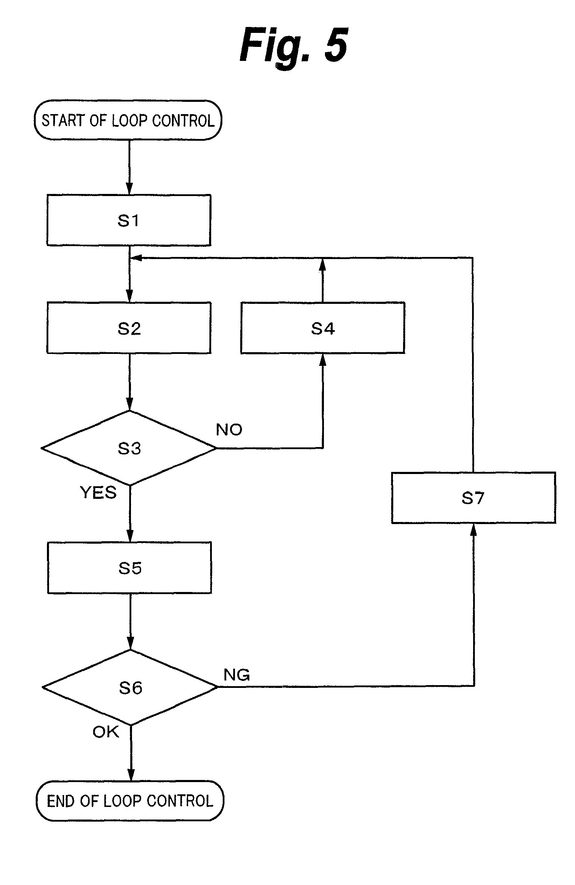

Fig. 5 is a flow chart showing a flow of a conventional quantization loop control process. When the process is started, first of all, at step S1, an initial value of a common scale factor is calculated. At step S2, quantization, the scaling is performed with the initial value that has been set.
At step S3, it is determined whether or not the quantizing noise for each sub band exceeds a permissible noise. The quantizing noise can be calculated by obtaining the difference between the inversely quantized MDCT coefficient and the pre-quantized MDCT coefficient. If the quantizing noise exceeds the permissible noise, the flow advances to step S4. At step S4, the sub band scale factor is changed such that the quantizing step size becomes small and the quantizing noise does not exceed the permissible noise.
At step S3, if it has been determined that the quantizing noise do not exceed be the permissible noise, the flow advances to step S5. At step S5, the variable length encoding is performed. Thereafter, at step S6, it is determined whether or not the encoded code amount exceeds a target code amount. The target code amount is a code amount that has been set for each frame. If it has been determined that the code amount exceed the target code amount, the flow advances to step S7. At step S7, the common scale factor is changed such that the quantizing step becomes large. Thereafter, the flow returns to step S2 (quantizing). Thereafter, at step S6, the foregoing process is repeated until it has been determined that the code amount do not exceed the target code amount.
Quantization in the AAC audio encoding is expressed as the following formula (1).

$$x\_quant = int\left(\left(abs\left(mdct\_line\right)*\left(2^\wedge\left(-1/4*\left(scalefactor - common\_scalefac\right)\right)\right)\right)^\wedge\left(3/4\right)+0.4054\right)$$

$$\cdots \quad (1)$$

In formula (1), mdctline represents a pre-quantized MDCT coefficient, xquant represents a quantized MDCT coefficient, scalefactor represents a sub band scale factor for each sub band, commonscalefac represents a common scale factor for an entire band, int() represents a process for obtaining an integer, abs represents a function for obtaining an absolute value, ^ represents a power, and * represents a multiplication. The integer obtainment process obtains an integer from abs to 0.4054. (scalefactor - commonscalefac) is referred to as a quantizing step.
As is clear from formula (1), the larger the sub band scale factor scalefactor becomes, the larger the quantized MDCT coefficient xquant becomes. In other words, the larger the sub band scale factor becomes, the smaller the quantizing step size becomes, resulting in decreasing the quantizing noise. However, since the quantizing coefficient becomes large, the code amount increases. In contrast, the larger the common scale factor becomes, the smaller the quantizing step size becomes, resulting in decreasing the code amount. Thus, the common scale factor and the sub band scale factor closely relate to the quantizing step size, namely the quantizing noise and the generated code amount. In such a manner, a loop control for updating these scale factors and repeating re-quantizing and re-encoding is performed.

At step S1 for calculating an initial value in the quantization loop process, the initial value of the sub band scale factor is set to 0 and the initial value of the common scale factor that starts is expressed by the following formula (2).

$$common\_scalefac = ceiling(16/3*(log_2((max\_mdct\_line\char94(3/4))/MAX\_QUANT)))$$

$$\cdots\ (2)$$

In formula (2), MAXQUANT represents the maximum value (fixed value) of quantizing coefficients in the AAC audio encoding standard, maxmdctline represents an MDCT coefficient whose absolute value in the entire band is the maximum, and ceiling(x) represents a function for obtaining the minimum integer value that is x or larger. In other words, the initial value of the common scale factor is the minimum common scale factor with which the Huffman encoding table is applicable for encoding.

As is clear from formula (2), the common scale factor is set such that a quantizing coefficient corresponding to the maximum value of the MDCT coefficients matches the maximum value MAX_QUANT in the standard. In addition, the sub band scale factor is set to 0. Thus, taking into account of the common scale factor, the quantizing step size is set to a very small value. In contrast, taking into account of the sub band scale factor, the quantizing step size is set to a flat frequency characteristic. In other words, the loop control always starts in the state that the code amount is very large regardless of the characteristic of the input signal. The common scale factor is gradually increased (namely, the quantizing step size is gradually increased) to decrease the generated code amount. In addition, while the sub band scale factor is increased corresponding to the input signal characteristic (namely, the quantizing step size is decreased), the quantizing distortion of each sub band is adjusted.

The loop process for repeating quantization while updating the sub band factor and the common scale factor until the quantized code amount does not exceed a target code amount is a process for searching the common scale factor with which the quantized code amount does not exceed the target code amount. Since other than the calculation result of the final loop process is not required, the loop process is a very ineffective process. Thus, since the process cost increases as the number of times of the loop increases, it is desired that the number of times of the loop be decreased.

The initial value of the common scale factor is the minimum value with which encoding can be performed as expressed in formula (2) and is a value that depends on the input signal regardless of the target code amount. On the other hand, the final value of the common scale factor tends to become large with a decrease of the target code amount (an increase of the compression ratio). Thus, the smaller the target code amount becomes, the larger the difference between the initial value of the common scale factor and the final value of the common scale factor, resulting in increasing the number of times of the quantization loop.

As methods for decreasing the number of times of the loop, two approaches can be considered. In the first method, a method of finding the final value of the common scale factor is improved. In the second method, a value close to the final value of the common scale factor is predicted as the initial value. As the first method for decreasing the number of times of the loop, the binary search is used instead of incrementing the common scale factor until it does not exceed the target code amount. As the second method, if the signal characteristics of adjacent frames are similar, the quantization loop process is started with the final value of the common scale factor of the preceding frame using a characteristic of which their final values of the common scale factor are similar values.

Japanese Patent Application Laid-Open No. 2004-172770 describes a technique of decreasing the process amount of the loop control for a decrease of the code amount in the AAC audio encoding to perform encoding at high speed.

The formula for quantization of the first time quantization loop in Japanese Patent Application Laid-Open No. 2004-1727770 is expressed by the following formula (3). In formula (3), endcommonscalefac(i-1) represents the final value of the common scale factor of the preceding frame.

$$x\_quant(i) = int((abs(mdct\_line(i))*(2\char94(-1/4*(end\_common\_scalefac(i-1)))))\char94(3/4)+0.4054)$$

$$\cdots\ (3)$$

The method of starting the quantization loop process with the final value of the common scale factor of the preceding frame in Japanese Patent Application Laid-Open No. 2004-172770 is effective if signal characteristics of adjacent frames are similar. However, if the signal characteristics vary, since the difference between the final value of the common scale factor of the preceding frame and the final value of the common scale factor of the current frame is large, the number of times of the quantization loop adversely increases.

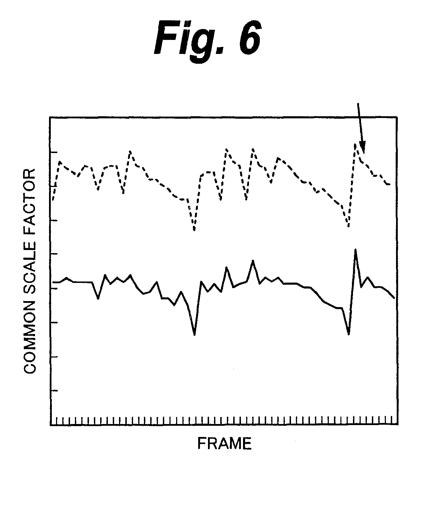

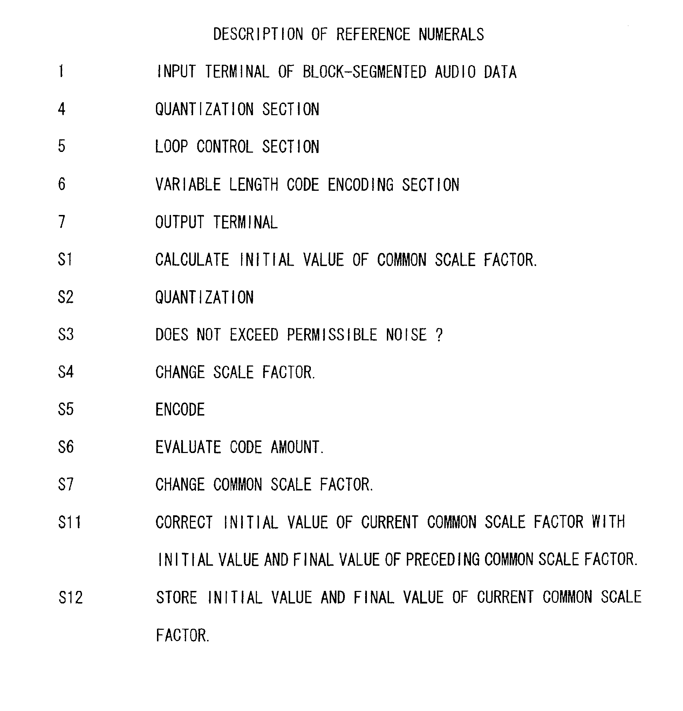

Fig. 6 shows an example of a variation (solid line) of the initial value of the common scale factor and a variation (broken line) of the final value of the common scale factor in the case that a symphony including a variation of an auditory characteristic as a sound source. When the final values of the common scale factors of adjacent frames are compared, although the final values do not largely vary, as represented by an arrow, they may largely differ. If the absolute value of the difference between the final value and the initial value of the common scale factor is large, it causes the number of times of the loop to increase. In the example shown in Fig. 6, taking into account of the absolute value of the final value and the initial value of the common scale factor, it is a relatively large value. In addition, it is clear that the absolute values of the differences of the adjacent frames are nearly the same regardless of variations of signal characteristics.

Thus, an object of the present invention is to provide an encoding method and an encoding apparatus that allow the number of times of the quantization loop to decrease in comparison with that of the related art.

Disclosure of the Invention

To solve the foregoing problem, according to the present invention, a quantization loop is started with a corrected initial value of the common scale factor as a value of which the difference between the initial value and the final value of the common scale factor of the preceding frame is added to the initial value of the common scale factor of the preceding frame. In addition, according to the present invention, the initial value of the common scale factor of the current frame is corrected with an increase ratio of the common scale factor of the preceding frame.

The present invention is in an encoding method for orthogonally transforming each block having a predetermined size of a digital information signal, obtaining frequency transform coefficients, separating the frequency transform coefficients into a plurality of sub bands, scaling and quantizing the frequency transform coefficients based on a sub band scale factor of each sub band and a common scale factor in common with an entire band, and encoding the quantized frequency transform coefficients according to variable length encoding, the encoding method comprising:

a step of calculating an initial value of the common scale factor;
an initial value correction step of correcting the initial value;
a sub band scale factor control step of changing the sub band scale factor such that a quantizing noise does not exceed a permissible value;
a common scale factor control step of changing the common scale factor until a final value of the common scale factor at which the code amount which has been encoded with the variable length code does not exceed a target code amount for each frame; and
a storage step of storing the initial value of the common scale factor and the final value of the common scale factor of a current frame,
wherein the initial value correction step is performed by adding an initial value of the common scale factor of a preceding frame and a final value of the common scale factor of the preceding frame to the initial value of the current frame.

The present invention is an encoding method of correcting the initial value of the scale factor of the current frame with an increase ratio of the common scale factor of the preceding frame instead of the difference between the initial value of the common scale factor of the preceding frame and the final value of the common scale factor of the preceding frame.

The present invention is in an encoding apparatus for orthogonally transforming each block having a predetermined size of a digital information signal, obtaining frequency transform coefficients, separating the frequency transform coefficients into a plurality of sub bands, scaling and quantizing the frequency transform coefficients based on a sub band scale factor of each sub band and a common scale factor in common with an entire band, and encoding the quantized frequency transform coefficients according to variable length encoding, the encoding method comprising:

means for calculating an initial value of the common scale factor;
initial value correction means for correcting the initial value;
sub band scale factor control means for changing the sub band scale factor such that a quantizing noise does not exceed a permissible value;
common scale factor control means for changing the common scale factor until a final value of the common scale factor at which the code amount which has been encoded with the variable length code does not exceed a target code amount for each frame; and
storage means for storing the initial value of the common scale factor and the final value of the common scale factor of a current frame,
wherein the initial value correction means adds an initial value of the common scale factor of a preceding frame and a final value of the common scale factor of the preceding frame to the initial value of the current frame.

The present invention is an encoding apparatus which corrects the initial value of the scale factor of the current frame with an increase ratio of the common scale factor of the preceding frame instead of the difference between the initial value of the common scale factor of the preceding frame and the final value of the common scale factor of the preceding frame.

Brief Description of Drawings

Fig. 1 is a block diagram showing an embodiment of the present invention;
Fig. 2 is a flow chart showing a flow of a process according to an embodiment of the present invention;
Fig. 3 is a schematic diagram exemplifying an initial value and a final value of a common scale factor according to an embodiment of the present invention;
Fig. 4 is a schematic diagram exemplifying the absolute value of the difference of the initial value and the final value of a common scale factor according to an embodiment of the present invention;
Fig. 5 is a flow chart showing a flow of a conventional code amount control; and
Fig. 6 is a schematic diagram exemplifying an initial value and a final value of a common scale factor in a conventional code amount control.

Best Modes for Carrying out the Invention

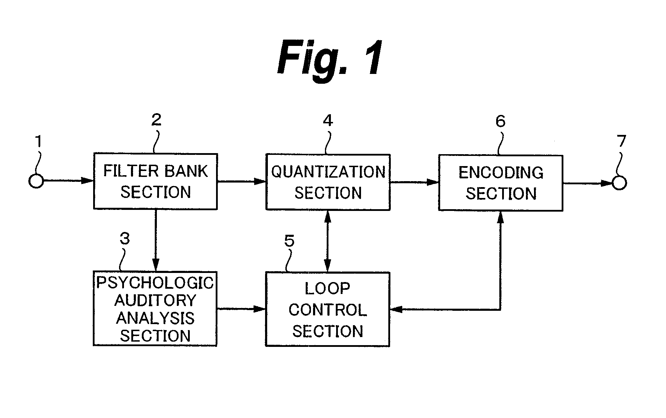

Next, with reference to the accompanying drawings, an embodiment of the present invention will be described. With reference to Fig. 1, the structure of an embodiment of the present invention will be described. A digital audio signal extracted as blocks having a predetermined size is input to an input terminal 1. The input audio signal is supplied to a filter bank section 2. The filter bank section 2 converts a time domain signal into a frequency domain signal according to an orthogonal transform, for example, MDCT. The orthogonally transformed signal is divided into sub bands. A sub band scale factor of each sub band is calculated and a normalization process for arranging their dynamic ranges is performed.
A psychologic auditory analysis section 3 properly assigns bits to each sub band using a human's psychologic auditory characteristic. An output signal of the filter bank section 2 is supplied to an quantization section 4. The quantization section 4 quantizes an MDCT coefficient supplied from the filter bank section 2 based on an analysis result of the psychologic auditory analysis section 3.
A loop control section 5 calculates a code amount that can be assigned to each encoding frame based on a predetermined encoding rate and information supplied from the psychologic auditory analysis section 3, treats the calculated code amount is a target code amount for the encoding frame, and updates a scaling factor for the quantization section 4 such that the code amount does not exceed the target code amount. An encoding section 6 compression-encodes the quantized MDCT coefficient that has been quantized by the quantization section 4 according to a predetermined encoding system. When the AAC audio encoding is performed, for example, the Huffman encoding system is applied as an encoding system. The encoded MDCT coefficient is obtained from an output terminal 7.

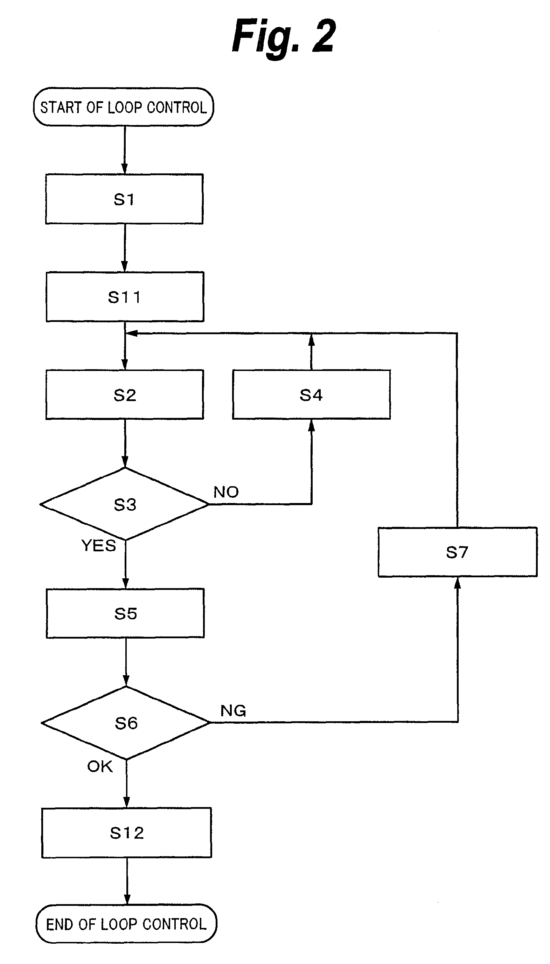

Fig. 2 is a flow chart showing a flow of a loop control process according to an embodiment of the present invention. In Fig. 2, steps corresponding to the conventional loop control shown in Fig. 5 are denoted by the same reference numerals except for step S11, "correct initial value of current common scale factor with initial value and final value of preceding common scale factor" and step S12, "store initial value and final value of current common scale factor".
When the process is started, the flow advances to step S1. At step S1, the initial value of the common scale factor is calculated. A formula for calculating the common scale factor of frame number i is expressed as the following formula (4).

$$start\_common\_scalefac\,(i) = ceiling\,(16/3 * (log_2\,((max\_mdct\_line\,(i)^\wedge(3/4))/MAX\_QUANT)))$$

$$\cdots\;(4)$$

Thereafter, at step S11, the initial value of the common scale factor is corrected. In other words, a value of which the difference between the initial value and the final value of the common scale factor of the preceding frame is added to the initial value of the common scale factor of the current frame is a corrected initial value of the common scale factor. The correction calculation formula is expressed as the following formula (5).

$$revised\_start\_common\_scalefac(i)$$
$$= start\_common\_scalefac(i)+(end\_common\_scalefac(i-1)-start\_common\_scalefac(i-1))$$

$$\cdots \quad (5)$$

where revisedstartcommonscalefac(i): corrected initial value of common scale factor,
startcommonscalefac(i): initial value of common scale factor (calculation result of formula (4)),
endcommonscalefac(i-1): final value of common scale factor of preceding frame;
startcommonscalefac(i-1): initial value of common scale factor of preceding frame.

At step S2, quantization, the scaling is performed with the initial value that has been set. A formula for calculating the quantization in the first quantization loop is expressed as the following formula (6).

$$x\_quant(i)$$
$$= int((abs(mdct\_line(i))*(2^{\wedge}(-1/4*(revised\_start\_common\_scalefac(i))))))^{\wedge}(3/4)+0.4054)$$

$$\cdots \quad (6)$$

When formula (3) used in the conventional process and formula (6) are compared, it is clear that the initial value of the common scale factor is changed from endcommonscalefac(i-1) to revisedstartcommonscalefac(i).

At step S3, it is determined whether the quantizing noise of each sub band exceeds a permissible noise. If the quantizing noise exceeds the permissible noise, the flow advances to step S4. At step S4, the sub band scale factor is changed such that the quantizing step size is decreased and the quantizing noise does not exceed the permissible noise.

When it has been determined that the quantizing noise do not exceed the permissible noise at step S3, the flow advances to step S5. At step S5, variable-length encoding is performed. At step S6, it is determined whether or not the encoded code amount exceeds a target code amount. When it has been determined that the code amount exceed the target code amount at step S6, the flow advances to step S7. At step S7, the common scale factor is changed such that the quantizing step is increased. Thereafter, the flow returns to step S2 (quantization). Thereafter, the foregoing process is repeated until it has been determined that the code amount do not exceed the target code amount at step S6. The control from these step S2 to step S7 are the same as that of the conventional process. However, it is likely that the corrected initial value of the common scale factor exceeds the final value. Thus, at step S7, the common scale factor is updated such that the common scale factor is not only increased, but decreased (searched). In the case of (corrected initial value > final value), at step S7, the common scale factor is changed such that it is monotonically decreased and a quantizing step immediately before (corrected initial value < final value) is satisfied becomes the final value.

If it has been determined that the code amount do not exceed the target code amount at step S6, the flow advances to step S12. At step S12, to perform the correction process for the initial value of the common scale factor of the next code amount, the initial value (startcommonscalefac(i)) and the final value (endcommonscalefac(i)) of the common scale factor of the current frame are stored. As a result, the loop control for the frame number i is completed.

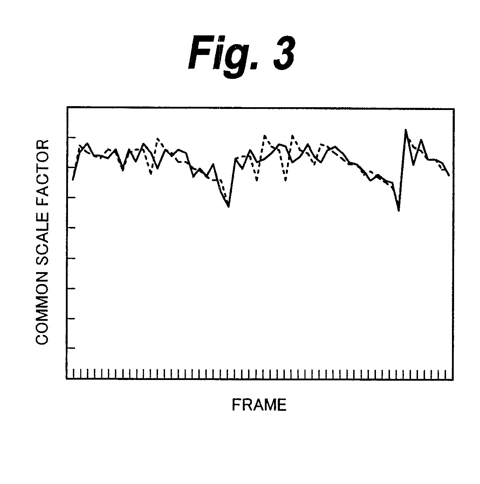

Fig. 3 shows the relationship between a corrected initial value (represented by a solid line) and a final value (represented by a dotted line) of the common scale factor in the case that the present invention is applied to the same sound source as that shown in Fig. 6. Fig. 3 shows that since the initial value and the final value of the common scale factor of the present invention are close, the number of times of the loop can be decreased.

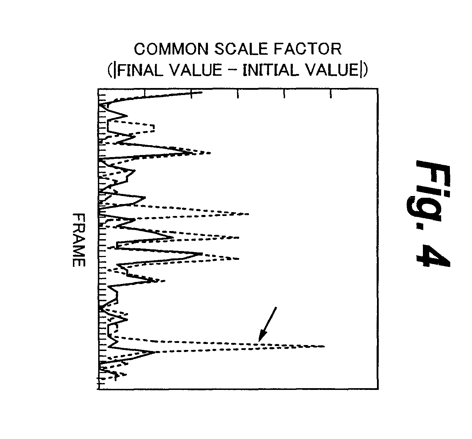

Fig. 4 shows an absolute value (represented by a dotted line) of the difference between an initial value and a final value of the common scale factor in the case that the conventional method is applied to the same sound source as that shown in Fig. 6 and an absolute value (represented by a solid line) of the difference in the case that the method according to this embodiment of the present invention is applied to the same sound source as that shown in Fig. 6. In the conventional method, as represented by an arrow, the difference between the initial value and the final value of the common scale factor at a location where a sound characteristic varies is as large as for example value 32. In contrast, in this embodiment of the present invention, the difference can be as small as value 3.

Since the difference between the initial value and the final value of the common scale factor affects the number of times of the quantization loop, when the difference is decreased, the number of times of the quantization loop can be decreased and thereby the quantization process can be performed at high speed. In particular, even if signal characteristics largely vary between adjacent frames, the quantization process can be performed as quickly as the case that they do not vary. In addition, since the initial value correction process is performed by a subtraction of obtaining the difference between the initial value of the common scale factor of the preceding frame and the final value of the common scale factor of the preceding frame and an addition of adding the difference to the initial value of the common scale factor, the hardware scale or software scale can be the same as that of the conventional apparatus or method.

Next, another example of a correction process for correcting the initial value of the common scale factor will be described. In this example, the initial value of the common scale factor is corrected with an increase ratio rather than the difference between the initial value and the final value of the common scale factor of the preceding frame. The correction process is expressed as the following formula (7).

$$revised\_common\_scalefac\,(i)$$
$$= start\_common\_scalefac\,(i) \times (end\_common\_scalefac\,(i-1) \div start\_common\_scalefac\,(i-1))$$
$$\cdot\,\cdot\,\cdot\,(7)$$

where revisedstartcommonscalefac(i): corrected initial value of common scale factor,
startcommonscalefac(i): initial value of common scale factor (calculation result of formula (4)),
endcommonscalefac(i-1): final value of common scale factor of preceding frame,
startcommonscalefac(i-1): initial value of common scale factor of preceding frame.

In formula (7), the term (endcommonscalefac(i-1) /startcommonscalefac(i-1) represents an increase rate. When the increase ratio is used instead of the difference, the same effect as described above can be obtained.

Although embodiments of the present invention have been specifically described, the present invention is not limited to such embodiments. In other words their various modifications may be performed based on the spirit of the present invention. For example, according to the present invention, to control a code amount for a target code amount, a large code amount may be controlled with a small code amount. In addition, the present invention can be applied to a code amount control for another audio encoding such as ISO/IEC 111718-4 (MPEG-1 Layer 3, MP3) rather than AAC audio encoding. In addition, the present invention can be also applied to a code amount control for video data rather than audio data.

According to the present invention, the difference between the initial value and the final value of the common scale factor can be small, the number of times of the quantization loop can be decreased, and the quantization process can be performed at high speed. In addition, according to the present invention, to correct the initial value of the common scale factor with the difference, only one addition/subtraction process and one comparison process need to be added per frame. Thus, the circuit scale and program scale of the apparatus of the present invention can be nearly the same as that of the conventional apparatus.

**Claims**

1. In an encoding method for orthogonally transforming each block having a predetermined size of a digital information signal, obtaining frequency transform coefficients, separating the frequency transform coefficients into a plurality of sub bands, scaling and quantizing the frequency transform coefficients based on a sub band scale factor of each sub band and a common scale factor in common with an entire band, and encoding the quantized frequency transform coefficients according to variable length encoding, the encoding method comprising:

   a step of calculating an initial value of the common scale factor;
   an initial value correction step of correcting the initial value;
   a sub band scale factor control step of changing the sub band scale factor such that a quantizing noise does not exceed a permissible value;
   a common scale factor control step of changing the common scale factor until a final value of the common scale factor at which the code amount which has been encoded with the variable length code does not exceed a target code amount for each frame; and
   a storage step of storing the initial value of the common scale factor and the final value of the common scale factor of a current frame,
   wherein the initial value correction step is performed by adding an initial value of the common scale factor of a preceding frame and a final value of the common scale factor of the preceding frame to the initial value of the current frame.

2. In an encoding method for orthogonally transforming each block having a predetermined size of a digital information signal, obtaining frequency transform coefficients, separating the frequency transform coefficients into a plurality of sub bands, scaling and quantizing the frequency transform coefficients based on a sub band scale factor of each sub band and a common scale factor in common with an entire band, and encoding the quantized frequency transform coefficients according to variable length encoding, the encoding method comprising:

a step of calculating an initial value of the common scale factor;

an initial value correction step of correcting the initial value;

a sub band scale factor control step of changing the sub band scale factor such that a quantizing noise does not exceed a permissible value;

a common scale factor control step of changing the common scale factor until a final value of the common scale factor at which the code amount which has been encoded with the variable length code does not exceed a target code amount for each frame; and

a storage step of storing the initial value of the common scale factor and the final value of the common scale factor of a current frame,

wherein the initial value correction step is performed by multiplying the initial value by an increase ratio of the common scale factor of a preceding frame.

3. The encoding method as set forth in claim 1 or claim 2,
wherein the initial value of the common scale factor is calculated with a frequency transform coefficient whose absolute value is maximum in the entire band.

4. The encoding method as set forth in claim 1 or claim 2,
wherein the initial value of the sub band scale factor is 0.

5. In an encoding apparatus for orthogonally transforming each block having a predetermined size of a digital information signal, obtaining frequency transform coefficients, separating the frequency transform coefficients into a plurality of sub bands, scaling and quantizing the frequency transform coefficients based on a sub band scale factor of each sub band and a common scale factor in common with an entire band, and encoding the quantized frequency transform coefficients according to variable length encoding, the encoding method comprising:

means for calculating an initial value of the common scale factor;

initial value correction means for correcting the initial value;

sub band scale factor control means for changing the sub band scale factor such that a quantizing noise does not exceed a permissible value;

common scale factor control means for changing the common scale factor until a final value of the common scale factor at which the code amount which has been encoded with the variable length code does not exceed a target code amount for each frame; and

storage means for storing the initial value of the common scale factor and the final value of the common scale factor of a current frame,

wherein the initial value correction means adds an initial value of the common scale factor of a preceding frame and a final value of the common scale factor of the preceding frame to the initial value of the current frame.

6. In an encoding apparatus for orthogonally transforming each block having a predetermined size of a digital information signal, obtaining frequency transform coefficients, separating the frequency transform coefficients into a plurality of sub bands, scaling and quantizing the frequency transform coefficients based on a sub band scale factor of each sub band and a common scale factor in common with an entire band, and encoding the quantized frequency transform coefficients according to variable length encoding, the encoding method comprising:

means for calculating an initial value of the common scale factor;

initial value correction means for correcting the initial value;

sub band scale factor control means for changing the sub band scale factor such that a quantizing noise does not exceed a permissible value;

common scale factor control means for changing the common scale factor until a final value of the common scale factor at which the code amount which has been encoded with the variable length code does not exceed a target code amount for each frame; and

storage means for storing the initial value of the common scale factor and the final value of the common scale factor of a current frame,

wherein the initial value correction means multiplies the initial value by an increase ratio of the common scale factor of a preceding frame.

# Fig. 1

# Fig. 2

# Fig. 3

FRAME

# Fig. 4

# Fig. 5

# Fig. 6

DESCRIPTION OF REFERENCE NUMERALS

| | |
|---|---|
| 1 | INPUT TERMINAL OF BLOCK-SEGMENTED AUDIO DATA |
| 4 | QUANTIZATION SECTION |
| 5 | LOOP CONTROL SECTION |
| 6 | VARIABLE LENGTH CODE ENCODING SECTION |
| 7 | OUTPUT TERMINAL |
| S1 | CALCULATE INITIAL VALUE OF COMMON SCALE FACTOR. |
| S2 | QUANTIZATION |
| S3 | DOES NOT EXCEED PERMISSIBLE NOISE ? |
| S4 | CHANGE SCALE FACTOR. |
| S5 | ENCODE |
| S6 | EVALUATE CODE AMOUNT. |
| S7 | CHANGE COMMON SCALE FACTOR. |
| S11 | CORRECT INITIAL VALUE OF CURRENT COMMON SCALE FACTOR WITH INITIAL VALUE AND FINAL VALUE OF PRECEDING COMMON SCALE FACTOR. |
| S12 | STORE INITIAL VALUE AND FINAL VALUE OF CURRENT COMMON SCALE FACTOR. |

## INTERNATIONAL SEARCH REPORT

| International application No. |
| --- |
| PCT/JP2007/059343 |

A. CLASSIFICATION OF SUBJECT MATTER
*G10L19/02*(2006.01)i, *H03M7/30*(2006.01)i

According to International Patent Classification (IPC) or to both national classification and IPC

B. FIELDS SEARCHED

Minimum documentation searched (classification system followed by classification symbols)
G10L19/02, H03M7/30

Documentation searched other than minimum documentation to the extent that such documents are included in the fields searched
Jitsuyo Shinan Koho        1922-1996   Jitsuyo Shinan Toroku Koho   1996-2007
Kokai Jitsuyo Shinan Koho   1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2001-306095 A (Mitsubishi Electric Corp.), 02 November, 2001 (02.11.01), Full text; all drawings (Family: none) | 1-6 |
| A | WO 2005/004113 A (Fujitsu Ltd.), 13 January, 2005 (13.01.05), Full text; all drawings & US 2006/074693 A1 | 1-6 |
| A | JP 2006-80927 A (TOA Corp., Tokyo Polytechnic University), 23 March, 2006 (23.03.06), Full text; all drawings (Family: none) | 1-6 |

| ☒ Further documents are listed in the continuation of Box C. | ☐ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 25 July, 2007 (25.07.07) | 07 August, 2007 (07.08.07) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

**INTERNATIONAL SEARCH REPORT**

| International application No. |
| --- |
| PCT/JP2007/059343 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 11-219197 A  (Fujitsu Ltd.), 10 August, 1999 (10.08.99), Full text; all drawings (Family: none) | 1-6 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004172770 A
- JP 20041727770 B